Europäisches Patentamt

European Patent Office

Office européen des brevets

(11) Veröffentlichungsnummer: **0 518 116 A1**

## EUROPÄISCHE PATENTANMELDUNG

(21) Anmeldenummer: **92108814.2**

(22) Anmeldetag: **26.05.92**

(51) Int. Cl.5: **G01R 19/25**, G01R 19/04, G01D 1/14

(30) Priorität: **08.06.91 DE 4118978**

(43) Veröffentlichungstag der Anmeldung:
**16.12.92 Patentblatt 92/51**

(84) Benannte Vertragsstaaten:
**DE GB**

(71) Anmelder: **Rohde & Schwarz GmbH & Co. KG**
**Mühldorfstrasse 15**

**W-8000 München 80(DE)**

(72) Erfinder: **Holeczek, Michael, Dipl.-Ing.**
**Römerstrasse 2a**
**W-8120 Weilheim(DE)**

(74) Vertreter: **Graf, Walter, Dipl.-Ing.**
**Sckellstrasse 1**
**W-8000 München 80(DE)**

(54) Verfahren zum Messen des Spitzenwertes einer Wechselspannung.

(57) Zum Messen des Spitzenwertes einer Wechselspannung werden folgende Verfahrensschritte angewendet:

die zu messende Wechselspannung wird durch Abtastung in Digitalwerte umgewandelt,

aus diesen Digitalwerten wird das Amplituden-Histogramm ermittelt,

durch Integration dieses Amplituden-Histogrammes wird dessen Verteilungsfunktion bestimmt, die damit der Wahrscheinlichkeit entspricht, mit der die Wechselspannung den jeweils zugeordneten Amplitudenwert überschreitet (Überschreitungswahrscheinlichkeit),

als oberer oder unterer Spitzenwert wird derjenige jeweils äuerste Amplitudenwert des Histogrammes bestimmt, dessen Überschreitungswahrscheinlichkeit gleich oder größer ist als ein vorgegebener Grenzwert, der größer als Null ist.

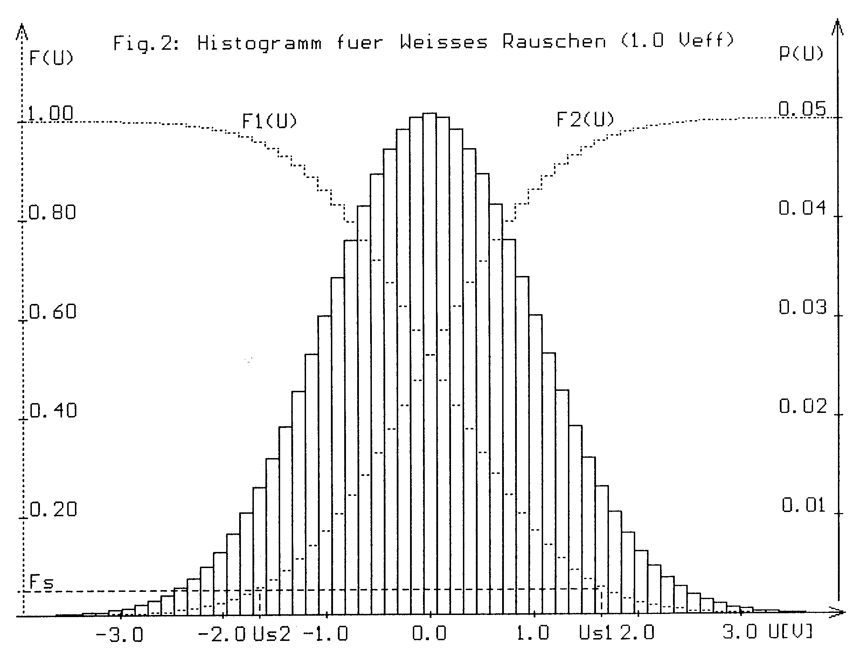

Fig.2: Histogramm fuer Weisses Rauschen (1.0 Ueff)

EP 0 518 116 A1

Die Erfindung betrifft ein Verfahren zum Messen des Spitzenwertes einer Wechselspannung, beispielsweise einer Rauschspannung, einer Sinusspannung, einer Rechteckspannung oder einem Gemisch hiervon.

Zum Messen des Mittelwertes oder des Effektivwertes einer Wechselspannung ist es bekannt, die zu messende Wechselspannung zunächst durch Abtastung in Digitalwerte umzuwandeln, aus diesen Digitalwerten dann das Amplituden-Histogramm zu ermitteln und daraus dann den Mittelwert oder den Effektivwert zu bestimmen (Hembach "Analog-Stochastik-Codierer für spezielle Anwendungen in der Meß- und Regelungstechnik", Frequenz 37 (1983) 3, S. 58 bis 63, DE 31 32 874).

Es ist Aufgabe der Erfindung, ein Verfahren dieser Art aufzuzeigen, mit dem auch die Spitzenwerte einer Wechselspannung gemessen werden können.

Diese Aufgabe wird gelöst durch ein Verfahren gemäß Hauptanspruch. Eine vorteilhafte Weiterbildung ergibt sich aus dem Unteranspruch.

Beim erfindungsgemäßen Verfahren werden nicht die jeweils äußersten Amplitudenwerte des Amplituden-Histogramms als oberer bzw. unterer Spitzenwert der abgetasteten Wechselspannung bestimmt, sondern diejenigen Amplitudenwerte des Histogramms, bei denen die Überschreitungswahrscheinlichkeit einen vorbestimmten Grenzwert erreicht oder überschreitet. Dieser Grenzwert hängt von der jeweiligen Meßaufgabe ab. Es hat sich als vorteilhaft erwiesen, diesen Grenzwert kleiner oder gleich dem Tastverhältnis einer Rechteckspannung zu wählen, die mit einem solchen Spitzenwertmesser noch richtig gemessen werden soll. Auf diese Weise ist eine Bewertung einer Wechselspannung möglich, wie dies bei Spitzenwertgleichrichtern in Analogtechnik üblich ist, denn durch entsprechende Wahl des Überschreitungswahrscheinlichkeits-Grenzwertes können die Lade- und Entlade-Zeitkonstanten eines analogen Spitzenwertgleichrichters auch in Digitaltechnik nachgebildet werden. Damit ist es erstmals möglich, auf digitalem Wege die gleiche Spitzenwertmessung wie mit einem analogen Spitzenwertgleichrichter durchzuführen.

Die Erfindung wird im folgenden anhand schematischer Zeichnungen an Ausführungsbeispielen näher erläutert.

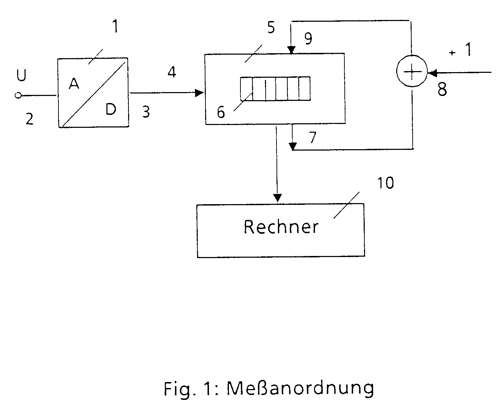

Fig. 1 zeigt den Prinzipaufbau einer Anordnung zum Ausführen des erfindungsgemäßen Verfahrens. Die Anordnung umfaßt einen üblichen A/D-Wandler 1, der mit einer beliebigen Abtastfrequenz von beispielsweise 18 MHz eine am Eingang 2 zugeführte analoge Wechselspannung in entsprechende Digitalwerte umwandelt. Die Datenausgänge 3 des A/D-Wandlers 1 sind mit den Adresseneingängen 4 eines Digitalspeichers (RAM) 5 verbunden. Jeder der schematisch angedeuteten Speicherstellen 6 des Speichers 5 ist ein entsprechender Amplitudenwert der Eingangswechselspannung zugeordnet. Zu Beginn einer Messung enthalten alle Speicherstellen 6 den Wert 0. Bei der Abtastung der Eingangswechselspannung wird für jeden der jeweiligen Abtastung entsprechenden Digitalwert die diesem zugeordnete Speicherstelle des Speichers 5 ausgelesen und über den Ausgang 7 einer Addierstufe 8 zugeführt, in welcher diesem jeweils ausgelesenen Wert der Speicherstelle ein Summand 1 hinzuaddiert wird, dieser um 1 inkrementierte Wert wird dann über den Dateneingang 9 wieder der entsprechenden Speicherstelle des Speichers 5 zugeführt und dort abgespeichert. Auf diese Weise wird die Speicherstelle, die dem Amplitudenwert des momentan abgetasteten Spannungswerte entspricht, um 1 erhöht. Diese Abtastung wird eine vorbestimmte Zeit lang wiederholt, bei genügender Wiederholung wird auf diese Weise im Speicher 5 das Amplituden-Histogramm der Eingangswechselspannung erzeugt. Der Ausgang des Speichers 5 ist außerdem mit einem Rechner 10 verbunden, in welchem die nachfolgende Auswertung dieses im Speicher erzeugten Histogramms erfolgt.

Fig. 2, 3 und 4 zeigen verschiedene Amplituden-Histogramme P(U) (durchgezogene Balken) für unterschiedliche Wechselspannungen, wie sie mit der Anordnung nach Fig. 1 im Speicher 5 erzeugbar sind. Auf der Abszisse ist die zu messende Wechselspannung U aufgetragen, die rechte Ordinate gibt den Maßstab für das Histogramm P(U) an, die linke Ordinate gibt den Maßstab für die sogenannte Überschreitungswahrscheinlichkeit F(U) an.

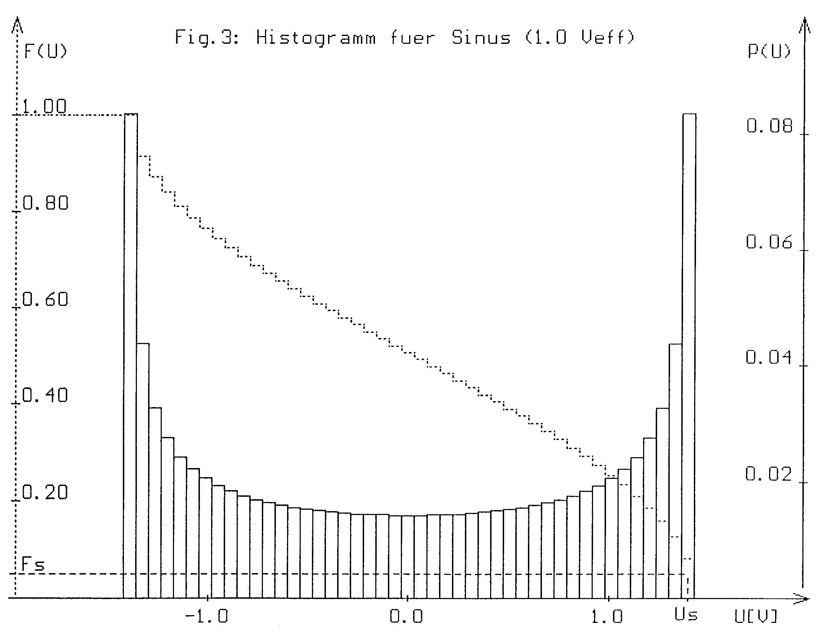

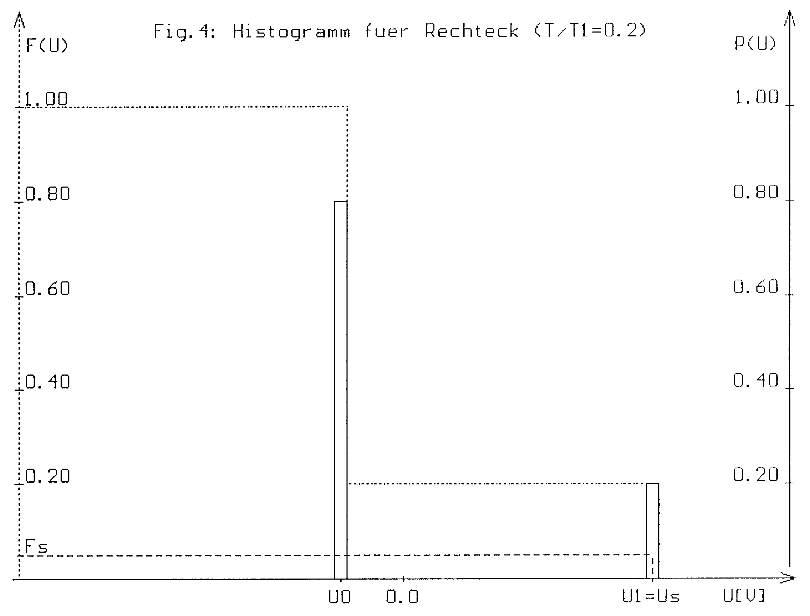

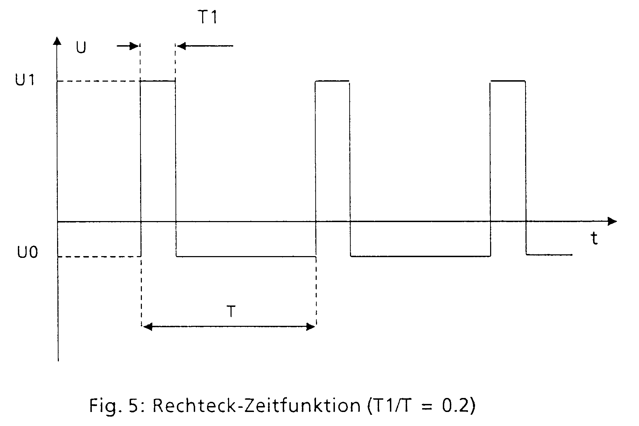

In den Fig. 2 bis 4 ist neben dem Amplituden-Histogramm P(U) auch noch die zugehörige Überschreitungswahrscheinlichkeit F(U) (gepunktete Linie) und ein Grenzwert $F_s$ dieser Überschreitungswahrscheinlichkeit (gestrichelte Linie) eingezeichnet. In der Mathematik wird diese Überschreitungswahrscheinlichkeitals Verteilungsfunktion eines Histogramms bezeichnet, im vorliegenden Fall entspricht diese sogenannte Verteilungsfunktion des Histogramms also der Wahrscheinlichkeit, mit der die Wechselspannung den jeweils zugeordneten Amplitudenwert überschreitet, sie wird daher als Überschreitungswahrscheinlichkeit bezeichnet und ergibt sich durch Integration des Histogrammes P(U). Die Kurve F1 zeigt die Überschreitungswahrscheinlichkeit für die Ermittlung des oberen Spitzenwertes, F2 zeigt die Überschreitungswahrscheinlichkeitskurve für die Ermittlung des unteren Spitzenwertes. Zur Ermittlung der Kurve F1 müssen für die Bestimmung der Überschreitungswahrscheinlichkeit F(x) einer Amplitudenstufe x alle Histogrammwerte P(U) aufsummiert werden, die auf oder rechts von der Amplitudenstufe x im Histogramm liegen. Für die Ermittlung der Kurve F2 gilt das Umgekehrte. Die Kurve F1 ist damit die Integralfunktion über das Histogramm mit negativer Integrationsrichtung und dient zur Ermittlung des oberen Spitzenwertes, die Kurve F2 entspricht der Integralfunktion über das Histogramm mit positiver Integrationsrichtung und dient zur Ermittlung des unteren Spitzenwertes. In den nachfolgenden Fig. 3 und 4 ist jeweils nur die Integralfunktion mit negativer Integrationsrichtung eingezeichnet, auch hier muß zur Ermittlung des unteren Spitzenwertes auch noch die Integralfunktion mit positiver Integrationsrichtung ermittelt werden.

Gemäß der Erfindung wird nicht unmittelbar der oberste oder unterste Wert des Histogramms als Spitzenwert genommen, sondern derjenige Amplitudenwert $U_s$ des Histogramms, bei dem die Überschreitungswahrscheinlichkeit F1 bzw. F2 einen vorbestimmten Grenzwert $F_s$ erreicht oder überschreitet. Dieser Grenzwert $F_s$ ist größer als Null, jedoch nicht größer als etwa 0,1, in einem praktischen Ausführungsbeispiel eines erfindungsgemäßen Spitzenwertmessers ist $F_s$ beispielsweise zwischen 0,00001 und 0,0001 gewählt. Dieser Grenzwert $F_s$ hängt von der jeweiligen Meßaufgabe ab. Zum Messen von Rauschen gemäß Fig. 2 wird der Grenzwert beispielsweise so gewählt, daß noch innerhalb vertretbarer Meßzeiten ein sinnvoller Spitzenwert gemessen wird, gemäß Fig. 2 wird also als oberer Spitzenwert $U_s$ gemessen, der mit größter Wahrscheinlichkeit nach kürzester Meßzeit erreicht wird. Durch die Einführung des Grenzwertes $F_s$ wird eine solche Spitzenwertmessung in sinnvolle Grenzen gebracht. Beim Messen einer Rechteckspannung wird dieser Grenzwert $F_s$ vorzugsweise kleiner oder gleich dem Tastverhältnis T1/T derjenigen Rechteckspannung gewählt, die mit einem solchen Spitzenwertmesser noch richtig gemessen werden soll. Durch die Einführung des Grenzwertes $F_s$ ist damit eine Spitzenwertmessung mit der gleichen Bewertung wie bei einem herkömmlichen analogen Spitzenwertgleichrichter möglich, bei dem eine Überschreitung des Spitzenwertes durch die Eingangsspannung notwendig ist, um die Entladung des Speicherkondensators auszugleichen. Die Auf- und Entladezeitkonstanten eines solchen Gleichrichters können also durch das erfindungsgemäße Verfahren auf digitale Weise nachgebildet werden.

Aus Fig. 2 ergibt sich, daß der Rechner bei der Ermittlung des Spitzenwertes von Rauschen nicht den ersten oberen Amplitudenwert als Spitzenwert ermittelt, sondern erst denjenigen Amplitudenwert $U_s$, bei dem die Überschreitungswahrscheinlichkeit F1 den vorbestimmten Grenzwert $F_s$ erreicht oder diesen überschreitet. Bei einem Sinussignal nach Fig. 3 ergibt sich aus der Überschreitungswahrscheinlichkeitskurve, daß tatsächlich der erste Amplitudenwert des Histogramms der richtige Wert ist, gleiches ergibt sich für die Rechteckspannung nach Fig. 4.

Der Rechner braucht also nur aus den ihm vom Speicher übermittelten Amplituden-Histogramm-Werten P(U) durch Integration die zugehörige Überschreitungswahrscheinlichkeitskurve F(U) ermitteln und für die Ermittlung des Spitzenwertes beginnend vom Rand der Histogrammkurve nach innen denjenigen Amplitudenwert $U_s$ bestimmen, bei dem das Integral F(U) die Überschreitungswahrscheinlichkeitsgrenze $F_s$ erreicht oder überschreitet. Der zugehörige Amplitudenwert $U_s$ ist dann der gewünschte in diesem Beispiel obere Spitzenwert der Eingangsspannung. In gleicher Weise kann auch der untere Spitzenwert (Minimalwert) einer Wechselspannung über den Rechner auf einfache Weise ermittelt werden.

Nach der Ermittlung des Histogramms wird vorzugsweise die Eingabe weiterer Digitalwerte in den Speicher unterbunden, damit der Rechner 10 die Auswertung durchführen kann. Die Zeit, in welcher das Histogramm ermittelt wird, ist abhängig von der jeweiligen Meßaufgabe, d.h. von dem jeweils zu verarbeitenden Meßsignal und der Abtastfrequenz. Es muß eine Mindestanzahl von Amplituden-Stichproben genommen werden, damit die Überschreitungswahrscheinlichkeitskurve in der Umgebung von $F_s$ genügend aussagekräftig, d.h. von statistischen Schwankungen weitgehend unabhängig ist. Die Abtastfrequenz hat keinen direkten Einfluß auf das Meßergebnis.

## Patentansprüche

1. Verfahren zum Messen des Spitzenwertes einer Wechselspannung, **gekennzeichnet** durch folgende Schritte:

   die zu messende Wechselspannung wird durch Abtastung in Digitalwerte umgewandelt;

   aus diesen Digitalwerten wird das Amplituden-Histogramm ermittelt;

   durch Integration dieses Amplituden-Histogrammes wird dessen Verteilungsfunktion bestimmt, die damit der Wahrscheinlichkeit entspricht, mit der die Wechselspannung den jeweils zugeordneten Amplitudenwert überschreitet (Überschreitungswahrscheinlichkeit),

   als oberer oder unterer Spitzenwert wird derjenige jeweils äußerste Amplitudenwert des Histogrammes bestimmt, dessen Überschreitungswahrscheinlichkeit gleich oder größer ist als ein vorgegebener Grenzwert, der größer als Null ist.

2.  Verfahren nach Anspruch 1, dadurch **gekennzeichnet,** daß der Grenzwert der Überschreitungswahrscheinlichkeit kleiner oder gleich dem Tastverhältnis einer Rechteckspannung ist, deren Spitzenwert noch richtig gemessen werden soll.

Fig. 1: Meßanordnung

Fig.2: Histogramm fuer Weisses Rauschen (1.0 Ueff)

Fig.3: Histogramm fuer Sinus (1.0 Veff)

EP 0 518 116 A1

Fig.4: Histogramm fuer Rechteck (T/T1=0.2)

EP 0 518 116 A1

Fig. 5: Rechteck-Zeitfunktion (T1/T = 0.2)

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5 ) |
|---|---|---|---|
| X | EP-A-0 182 989 (IBM)<br>* Spalte 2, Zeile 44 - Spalte 3, Zeile 40 *<br>* Spalte 5, Zeile 38 - Zeile 66 *<br>* Spalte 6, Zeile 21 - Zeile 42; Abbildungen 1,2,4-6 *<br>--- | 1 | G01R19/25<br>G01R19/04<br>G01D1/14 |
| A | PATENT ABSTRACTS OF JAPAN<br>vol. 15, no. 184 (P-1200)13. Mai 1991<br>& JP-A-3 042 576 ( FUJITSU ) 22. Februar 1991<br>* Zusammenfassung *<br>--- | 1 | |
| A | RADIO FERNSEHEN ELEKTRONIK.<br>Bd. 35, Nr. 11, 1986, BERLIN DD<br>Seiten 735 - 736;<br>W. MICHEL: 'DIGITALER SPITZENWERTMESSER'<br>* das ganze Dokument *<br>--- | 1 | |
| A | S. BRANDT: 'DATENANALYSE', 1975, B.I. - WISSEN-SCHAFTSVERLAG, MANNHEIM, DE<br>* Seite 29, Absatz 3 -letzter Absatz; Abbildungen 3.4,3.5 *<br>--- | 1 | **RECHERCHIERTE SACHGEBIETE (Int. Cl.5 )** |
| A | PATENT ABSTRACTS OF JAPAN<br>vol. 12, no. 175 (P-707)25. Mai 1988<br>& JP-A-62 287 165 ( NEC ) 14. Dezember 1987<br>* Zusammenfassung *<br>----- | 2 | G01R |

Der vorliegende Recherchenbericht wurde für alle Patentansprüche erstellt

| Recherchenort | Abschlußdatum der Recherche | Prüfer |
|---|---|---|
| DEN HAAG | 04 SEPTEMBER 1992 | SINAPIUS G.H. |